# EUROPEAN PATENT SPECIFICATION

(11) **EP 3 165 549 B1**
(45) Date of publication and mention of the grant of the patent: **16.06.2021**
(21) Application number: 15815767.7
(22) Date of filing: 01.07.2015
(51) Int. Cl.: C08G 59/24

(54) **EPOXY RESIN COMPOSITION FOR ELECTRONIC MATERIAL, CURED PRODUCT THEREOF AND ELECTRONIC MEMBER**
EPOXIDHARZZUSAMMENSETZUNG FÜR ELEKTRONISCHES MATERIAL, GEHÄRTETES PRODUKT DARAUS UND ELEKTRONISCHES BAUTEIL
COMPOSITION DE RÉSINE ÉPOXY POUR MATÉRIAU ÉLECTRONIQUE, PRODUIT DURCI DE CELLE-CI ET ÉLÉMENT ÉLECTRONIQUE

(30) Priority: 02.07.2014 JP 2014136773
(43) Date of publication of application: 10.05.2017
(73) Proprietor: DIC Corporation, Tokyo 174-8520 (JP)
(72) Inventor: YOSHIMOTO Yasuyo, Sakura-shi Chiba 285-8668 (JP); KINOSHITA Hiroshi, Sakura-shi Chiba 285-8668 (JP)
(74) Representative: Beckmann, Claus
(86) International application number: PCT/JP2015/068957
(87) International publication number: WO 2016/002833

(56) References cited:
- WO-A1-2014/185485
- WO-A1-2015/093461
- JP-A- H0 270 780
- JP-A- H11 147 936
- JP-B2- 2 953 661
- US-A- 3 374 203
- US-A- 3 721 644
- US-A1- 2010 080 998

## Description

### Technical Field

The present invention relates to an epoxy resin composition for electronic material which is excellent in heat resistance, low thermal expansion, and thermal conductivity of a cured product thereof, a cured product thereof, and an electronic component.

### Background Art

An epoxy resin composition including an epoxy resin and a curing agent or a curing accelerator as essential components is, in point of being excellent in various properties such as heat resistance and moisture absorption resistance, widely used in a semi-laminated plate resin material, an electrical insulating material, a semiconductor encapsulation material, a fiber-reinforced composite material, a coating material, a molding material, an adhesive material, and the like. In recent years, in the field of electronic component, heat generation density is notably increased because of a tendency toward miniaturization and higher-density packaging, and in epoxy resin compositions used in various constituting components, further improvement in heat resistance, thermal expansion and thermal conductivity is demanded. Especially for an epoxy resin composition used in an insulating portion, there is a limit in enhancing thermal conductivity by using a heat dissipating filler, and it is demanded to increase thermal conductivity of the epoxy resin itself which is a matrix.

As an epoxy resin excellent in thermal conductivity, one having a mesogenic skeleton is known, and for example, PTL 1 and PTL 2 describe a bisphenol type epoxy resin and an epoxy resin with various mesogenic skeletons. However, these epoxy resins are poor in heat resistance due to a small number of epoxy functional groups, and therefore it is difficult to use the epoxy resins for the electronic material application in which stability under high temperature conditions is more demanded in future. In particular, an epoxy resin having a mesogenic structure described in PTL 2 is problematic in difficulty in synthesis and poor workability due to the high melting point and poor solubility in solvents.

PTL 3 and PTL 4 describe that a polyfunctional biphenyl type epoxy resin that is a triglycidyloxybiphenyl and a tetraglycidyloxybiphenyl can be used for the electronic material application, and many other patent literatures have similar descriptions. However, none of the patent literatures has a description about the physical properties thereof, or a description focusing on thermal conductivity of the epoxy resin.

US 2010/080998 A1 describes an epoxy resin composition that is said to be excellent in thermal conductivity and has improved high-temperature resistance and handleability. The epoxy resin composition comprises an epoxy compound having a mesogenic skeleton and a curing agent having a biphenylaralkyl skeleton. The biphenylaralkyl skeleton-containing curing agent preferably has a softening point of 110 °C or lower. The biphenylaralkyl skeleton-containing curing agent is preferably an amorphous curing agent.

JP H11 147936 A rellates to the problem to obtain an epoxy resin composition which can give a cured product reduced in warpage at room temperature or in a soldering step, having excellent reliability such as soldering resistance and thermal cycling resistance by forming an epoxy resin composition comprising an epoxy resin, a phenolic resin curing agent, a cure accelerator, and an inorganic filler, wherein a specified amount of aluminum nitride is used as a part of the inorganic filler. As a solution to the problem, the document describes an epoxy resin which comprises 5-90 wt.% polyfunctional epoxy resin represented by the following formula (1) (wherein R is a halogen or a 1-12C alkyl; (1) is 1-10; (m) is 0 or 1-3; and (n) is 0 or 1-4) or the like and at least 10 wt.% crystalline epoxy resin represented by the following formula (2) (wherein R is H, a halogen, or a 1-12C alkyl) or the like and having a melting point of 50-150 °C. The phenolic resin curing agent is represented by the following formula (3) (the symbols are as defined above) and is exemplified by a triphenolmethane type phenolic resin. The cure accelerator is tributylamine or the like. The aluminum nitride is used in an amount of 20-85 wt.% based on the total epoxy resin composition.

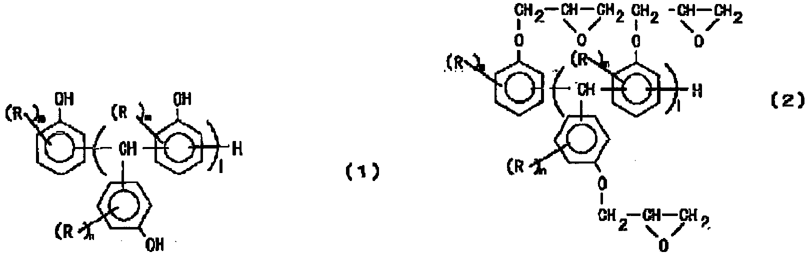

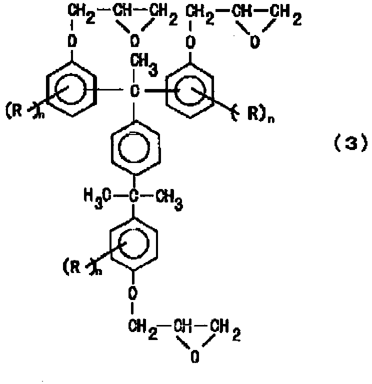

### Citation List

### Patent Literature

PTL 1: JP-A-2010-001427
PTL 2: JP-A-11-323162
PTL 3: Japanese Patent No. 2953661
PTL 4: Japanese Patent No. 5416367

### Summary of Invention

### Technical Problem

The problem to be solved by the invention is to provide an epoxy resin composition for electronic material which exhibits excellent heat resistance, thermal expansion, and high thermal conductivity, and further realizes good workability due to low viscosity characteristic and good solvent solubility thereof, and a cured product thereof.

### Solution to Problem

As a result of intensive studies, the present inventors have found that a polyfunctional biphenyl type epoxy resin that is a triglycidyloxybiphenyl or a tetraglycidyloxybiphenyl has a low melting point and low viscosity and shows a good solvent solubility, a composition thereof shows a good low viscosity characteristic and solvent solubility, and in addition, a cured product thereof shows a high thermal conductivity due to the biphenyl skeleton and an excellent heat resistance and a low thermal expansion in a high temperature region due to the polyfunctional design, thereby completing the present invention. Since the epoxy. resin shows a very low viscosity when melting, there is no need to use another diluent with a low thermal conductivity together for lowering the melting point and viscosity, and therefore a cured product having a high thermal conductivity can be obtained also from a practical composition prepared by using the epoxy resin.

Specifically, the present invention relates to an epoxy resin composition for electronic material, including as essential components, an epoxy resin represented by the following formula (1), that is, a polyfunctional biphenyl type epoxy resin that is a triglycidyloxybiphenyl or a tetraglycidyloxybiphenyl, at least one of a curing agent and a curing accelerator, and a thermal conductive filler having a thermal conductivity of 10 W/m/K or higher which has been modified at the surface by a silane-based coupling agent. 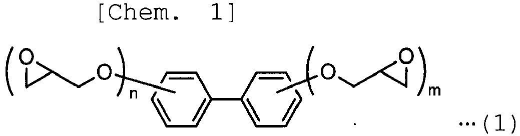 In the formula, n and m each represents an integer of 0 to 4, provided that the sum of n and m is 3 or 4.

Furthermore, the present invention relates to the epoxy resin composition for electronic material, which contains a silica as the filler.

Furthermore, the present invention relates to the above epoxy resin composition for electronic material, which further contains a fibrous base material.

Furthermore, the present invention relates to the epoxy resin composition for electronic material, which is a thermal conductive adhesive.

Furthermore, the present invention relates to the epoxy resin composition for electronic material, which is for a semiconductor encapsulation material.

Furthermore, the present invention relates to the epoxy resin composition for electronic material, which is for an electronic circuit board material.

Furthermore, the present invention related to an epoxy resin cured product for electronic material, which is obtained by subjecting the above epoxy resin composition for electronic material to a curing reaction.

Furthermore, the present invention relates to an electronic component, which contains the above epoxy resin cured product for electronic material.

Furthermore, the present invention relates to the electronic component, which is a thermal conductive adhesive, a semiconductor encapsulation material, or an electronic circuit board.

### Advantageous Effects of Invention

The epoxy resin of the present invention can provide an epoxy resin composition for electronic material which realizes good solvent solubility and low viscosity, and an epoxy resin cured product for electronic material which exhibits excellent heat resistance, low thermal expansion, and high thermal conductivity, and can be suitably used in electronic materials such as a thermal conductive adhesive, a semiconductor encapsulation material, a printed wiring board material, a flexible wiring board material, an interlayer insulating material for buildup substrate, a conductive paste, an adhesive film material for buildup, a resist ink, a resin casting material, and an adhesive. In particular, the epoxy resin of the present invention can be especially suitably used for a thermal conductive material owing to the excellent thermal conductivity.

### Description of Embodiment

The present invention will be described in detail below.

The epoxy resin used in the present invention is a polyfunctional biphenyl type epoxy resin that is a triglycidyloxybiphenyl or a tetraglycidyloxybiphenyl, that is, an epoxy resin represented by the aforementioned formula (1). Examples of the epoxy resin represented by the aforementioned formula (1) include 2,3,4-triglycidyloxybiphenyl, 2,3,5-triglycidyloxybiphenyl, 2,3,6-triglycidyloxybiphenyl, 2,4,5-triglycidyloxybiphenyl, 2,4,6-triglycidyloxybiphenyl, 3,4,5-triglycidyloxybiphenyl, 2,2',3-triglycidyloxybiphenyl, 2,2',4-triglycidyloxybiphenyl, 2,2',5-triglycidyloxybiphenyl, 2,2',6-triglycidyloxybiphenyl, 2,3',4'-triglycidyloxybiphenyl, 2,3',5'-triglycidyloxybiphenyl, 2,3,3'-triglycidyloxybiphenyl, 2,3',4-triglycidyloxybiphenyl, 2,3',5-triglycidyloxybiphenyl, 2,3',6-triglycidyloxybiphenyl, 3,3',4-triglycidyloxybiphenyl, 3,3'5-triglycidyloxybiphenyl, 2,3,4'-triglycidyloxybiphenyl, 2,4,4'-triglycidyloxybiphenyl, 2,4',5-triglycidyloxybiphenyl, 2,4',6-triglycidyloxybiphenyl, 3,4,4'-triglycidyloxybiphenyl, 3,4',5-triglycidyloxybiphenyl, 2,3,4,5-tetraglycidyloxybiphenyl, 2,3,4,6-tetraglycidyloxybiphenyl, 2,3,5,6-tetraglycidyloxybiphenyl, 2,2',3,4-tetraglycidyloxybiphenyl, 2,2',3,5-tetraglycidyloxybiphenyl, 2,2',3,6-tetraglycidyloxybiphenyl, 2,2',4,5-tetraglycidyloxybiphenyl, 2,2',4,6-tetraglycidyloxybiphenyl, 2,3',4',5'-tetraglycidyloxybiphenyl, 2,3,3',4-tetraglycidyloxybiphenyl, 2,3,3',5-tetraglycidyloxybiphenyl, 2,3,3',6-tetraglycidyloxybiphenyl, 2,3',4,5-tetraglycidyloxybiphenyl, 2,3',4,6-tetraglycidyloxybiphenyl, 3,3',4,5-tetraglycidyloxybiphenyl, 2,3,4,4'-tetraglycidyloxybiphenyl, 2,3,4',5-tetraglycidyloxybiphenyl, 2,3,4',6-tetraglycidyloxybiphenyl, 2,4,4',5-tetraglycidyloxybiphenyl, 2,4,4',6-tetraglycidyloxybiphenyl, 3,4,4',5-tetraglycidyloxybiphenyl, 2,2',3,3'-tetraglycidyloxybiphenyl, 2,2',3,4'-tetraglycidyloxybiphenyl, 2,2',3,5'-tetraglycidyloxybiphenyl, 2,2',3,6'-tetraglycidyloxybiphenyl, 2,3,3',4'-tetraglycidyloxybiphenyl, 2,3,3',5'-tetraglycidyloxybiphenyl, 2,2',4,4'-tetraglycidyloxybiphenyl, 2,2',4,5'-tetraglycidyloxybiphenyl, 2,2',4,6'-tetraglycidyloxybiphenyl, 2,3',4,4'-tetraglycidyloxybiphenyl, 2,3',4,5'-tetraglycidyloxybiphenyl, 2,2',5,5'-tetraglycidyloxybiphenyl, 2,2',5,6'-tetraglycidyloxybiphenyl, 2,3',4',5-tetraglycidyloxybiphenyl, 2,3',5,5'-tetraglycidyloxybiphenyl, 2,2',6,6'-tetraglycidyloxybiphenyl, 2,3',4',6-tetraglycidyloxybiphenyl, 2,3',5',6-tetraglycidyloxybiphenyl, 3,3',4,4'-tetraglycidyloxybiphenyl, 3,3',4,5'-tetraglycidyloxybiphenyl, and 3,3',5,5'-tetraglycidyloxybiphenyl. Among them, since a highly-oriented molecular structure is advantageous for increasing thermal conductivity of an epoxy resin, suitable are 2,4,4'-triglycidyloxybiphenyl, 2,4,4',6-tetraglycidyloxybiphenyl, and 2,2',4,4'-tetraglycidyloxybiphenyl, which have substituents at the 4,4'-position; and 2,4',6-triglycidyloxybiphenyl, 3,4',5-triglycidyloxybiphenyl, 2,2',5,5'-tetraglycidyloxybiphenyl, and 3,3',5,5'-tetraglycidyloxybiphenyl, which are excellent in molecular symmetry.

Furthermore, in the epoxy resin represented by the aforementioned formula (1), a part of the hydrogen atoms bound to the aromatic rings may be substituted by hydrocarbon groups. The hydrocarbon group may be a hydrocarbon group having 1 to 10 carbon atoms which may have a substituent, and examples thereof include alkyl groups such as a methyl group, an ethyl group, an isopropyl group, and a cyclohexyl group; alkenyl groups such as a vinyl group, an allyl group, and a cyclopropenyl group; alkynyl groups such as an ethynyl group and a propynyl group; aryl groups such as a phenyl group, a tolyl group, a xylyl group, and a naphthyl group; and aralkyl groups such as a benzyl group, a phenethyl group, and a naphthyl methyl group. As the substituent mentioned above, any substituent may be incorporated as long as it does not significantly affect the epoxy resin composition for electronic material of the present invention and a cured product thereof. For lowering the melt viscosity of the epoxy resin, a long chain alkyl group, alkenyl group, and alkynyl group, which have high mobility, are preferred, but such a substituent having high mobility may deteriorate heat resistance of an epoxy resin cured product. In addition, a highly bulky substituent may inhibit the molecular orientation and reduce the thermal conductivity. Accordingly, in the epoxy resin of the present invention, it is preferred that no substituent is incorporated or the substituent is a hydrocarbon group having 1 to 4 carbon atoms, and it is further preferred that no substituent is incorporated or the substituent is a methyl group or an allyl group.

Trihydroxybiphenyl or tetrahydroxybiphenyl which is a raw material of the polyfunctional biphenyl type epoxy resin represented by the formula (1) of the present invention may be a byproduct in production of resorcinol and the like, or may be intentionally produced using a commonly known method. Examples of the method for intentionally producing the compound include various reactions for dimerizing benzene, monohydroxybenzene, dihydroxybenzene, trihydroxybenzene, and tetrahydroxybenzene, or a derivative thereof. For example, a coupling reaction may be mentioned, in which any one or two of benzene, monohydroxybenzene, dihydroxybenzene, trihydroxybenzene, tetrahydroxybenzene, a halogenide of the above compounds, a silane derivative, a tin derivative, a lithium derivative, a boronic acid derivative, a sulfonic acid derivative such as a trifluoromethanesulfonic acid, an alkoxy derivative, a magnesium halide derivative, an zinc halide derivative, and the like are allowed to react with a metal catalyst to build a biphenyl skeleton. In the above reactions, an oxidation coupling reaction in which a metal catalyst such as iron and copper is used (Tetrahedron Letters, 1977, 50, 4447); and a coupling reaction in which a metal catalyst such as copper and palladium is used, such as the Ullmann reaction (Chem. Ber. 1901, 34, 2174) and the Suzuki coupling reaction (J. Organomet. Chem., 576, 147(1999); Synth. Commun., 11, 513 (1981)), are suitable because of the simplicity and a good yield.

The method for producing the epoxy resin represented by the formula (1) of the present invention is not particularly limited and the epoxy resin can be produced by a commonly known method. Examples thereof include a production method in which an epihalohydrin is allowed to react with trihydroxybiphenyl or tetrahydroxybiphenyl, and a production method in which an ally halide is allowed to react with trihydroxybiphenyl or tetrahydroxybiphenyl to produce an allyl ether, and then the allyl ether is cyclized into an epoxy ring through an oxidation reaction or through a halohydrin form. In industrial production, the production method in which an epihalohydrin is allowed to react with trihydroxybiphenyl or tetrahydroxybiphenyl is significant. An example thereof will be described detail below.

Specific examples of the production method in which an epihalohydrin is allowed to react with a phenol compound include a method in which an epihalohydrin is added in such an amount that a ratio of the epihalohydrin is 2 to 10 times (on a molar basis) relative to the mole number of the phenolic hydroxy group in the phenol compound, and while further adding a basic catalyst at a time or gradually in such an amount that the ratio of the basic catalyst is 0.9 to 2.0 times (on a molar basis) relative to the mole number of the phenolic hydroxy group, the mixture is allowed to react at a temperature of 20 to 120°C for 0.5 to 10 hours. The basic catalyst may be used in a solid form or in an aqueous solution. When an aqueous solution is used, a method in which while continuously adding the basic catalyst, water and an epihalohydrin are continuously distilled from the reaction mixture under reduced pressure or normal pressure, the reaction mixture is further separated to remove water, and the epihalohydrin is continuously returned to the reaction mixture, may be used.

Incidentally, in the case of industrial production, all the epihalohydrin used for charging is new materials in the first batch of an epoxy resin production, but in the next and later batches, the epihalohydrin recovered from the crude reaction product can be used in combination with a new epihalohydrin in an amount corresponding to the amount that is consumed and lost in the reaction, and this manner is economically preferred. In this case, the epihalohydrin used is not particularly limited, and examples thereof include epichlorohydrin, epibromohydrin, and β-methylepichlorohydrin. Among them, epichlorohydrin is preferred because of industrial availability.

Specific examples of the basic catalyst include an alkali earth metal hydroxide, an alkali metal carbonate, and an alkali metal hydroxide. An alkali metal hydroxide is particularly preferred in point of excellent catalytic activity in an epoxy resin synthesis reaction, and examples thereof include sodium hydroxide and potassium hydroxide. In use, the basic catalyst may be used in a form of an aqueous solution of approximately from 10 to 55% by mass, or may be used in a form of solid. In addition, by using an organic solvent together, the reaction rate in the synthesis of the epoxy resin can be increased. The organic solvent is not particularly limited, and examples thereof include ketones such as acetone and methyl ethyl ketone, alcohols such as methanol, ethanol, 1-propyl alcohol, isopropyl alcohol, 1-butanol, sec-butanol, and tert-butanol, cellosolves such as methyl cellosolve and ethyl cellosolve, ethers such as tetrahydrofuran, 1,4-dioxane, 1,3-dioxane, and diethoxyethane, and aprotic polar solvents such as acetonitrile, dimethylsulfoxide, and dimethyl formamide. The organic solvents each may be used alone or two or more thereof may be appropriately used in combination for adjusting the polarity.

The reaction product of the epoxidation reaction described above is washed with water, and then, the unreacted epihalohydrin and the organic solvent used together are removed by distillation under heat and reduced pressure. For producing an epoxy resin containing a smaller amount of hydrolyzable halogen, it is possible that the obtained epoxy resin is dissolved again in an organic solvent such as toluene, methyl isobutyl ketone, and methyl ethyl ketone, and then an aqueous solution of an alkali metal hydroxide such as sodium hydroxide and potassium hydroxide is added to perform a further reaction. In this case, for the purpose of enhancing the reaction rate, a phase transfer catalyst such as a quaternary ammonium salt and a crown ether may be allowed to exist. In the case of using a phase transfer catalyst, the use amount is preferably such an amount that the proportion of the phase transfer catalyst is 0.1 to 3.0 parts by mass relative to 100 parts by mass of the epoxy resin used. After the completion of the reaction, the produced salt is removed by filtration, water washing, or the like, and further the solvent such as toluene and methyl isobutyl ketone is removed by distillation under heat and reduced pressure, whereby the intended epoxy resin represented by the formula (1) which is an essential component of the present invention can be obtained.

Next, while the epoxy resin composition for electronic material of the present invention includes the epoxy resin represented by the formula (1) described in detail above and a curing agent or a curing accelerator as essential components, the epoxy resin may be used in a form of a reaction product in the production containing oligomer components.

The curing agent used here is not particularly limited, and any of compounds usually used as a curing agent of an epoxy resin can be used. Examples thereof include an amine compound, an amide compound, an acid anhydride compound, and a phenolic compound. Specific example of the amine compound include diaminodiphenylmethane, diaminodiphenylethane, diaminodiphenyl ether, diaminodiphenyl sulfone, o-phenylenediamine, m-phenylenediamine, p-phenylenediamine, m-xylenediamine, p-xylenediamine, diethyltoluenediamine, diethylenetriamine, triethylenetetramine, isophoronediamine, imidazole, a BF3-amine complex, a guanidine derivative, and a guanamine derivative. Examples of the amide compound include dicyandiamide and a polyamide resin synthesized from linolenic acid dimer and ethylenediamine. Examples of the acid anhydride compound include phthalic anhydride, trimellitic anhydride, pyromellitic anhydride, maleic anhydride, tetrahydrophthalic anhydride, methyltetrahydrophthalic anhydride, methylnadic anhydride, hexahydrophthalic anhydride, and methylhexahydrophthalic anhydride. Examples of the phenolic compound include bisphenol A, bisphenol F, bisphenol S, resorcin, catechol, hydroquinone, fluorene bisphenol, 4,4'-biphenol, 4,4',4"-trihydroxytriphenylmethane, naphthalene diol, 1,1,2,2-tetrakis(4-hydroxyphenyl)ethane, calixarene, a phenol novolac resin, a cresol novolac resin, an aromatic hydrocarbon formaldehyde resin-modified phenol resin, a dicyclopentadiene-phenol addition type resin, a phenol aralkyl resin (Xylok resin), polyhydric phenol novolac resin synthesized from a polyhydric hydroxy compound typified by a resorcin novolac resin and formaldehyde, a naphthol aralkyl resin, a trimethylolmethane resin, a tetraphenylolethane resin, a naphthol novolac resin, a naphthol-phenol co-condensed novolac resin, a naphthol-cresol co-condensed novolac resin, and polyhydric phenol compounds, such as a biphenyl-modified phenol resin (a polyhydric phenol compound in which phenol nuclei are linked via a bismethylene group), a biphenyl-modified naphthol resin (a polyhydric naphthol compound in which phenol nuclei are linked via a bismethylene group), an aminotriazine-modified phenol resin (a polyhydric phenol compound in which phenol nuclei are linked via melamine, benzoguanamine, and the like), and an alkoxy group-containing aromatic ring-modified novolac resin (a polyhydric phenol compound in which a phenol nucleus and an alkoxy group-containing aromatic ring are linked via formaldehyde). The curing agents each may be used alone or two or more thereof may be used in combination.

In the epoxy resin composition for electronic material of the present invention, a curing accelerator may be used alone or in combination with a curing agent. As the curing accelerator, various compounds that facilitate a curing reaction of an epoxy resin may be used, and examples thereof include a phosphorus-based compound, a tertiary amine compound, an imidazole compound, an organic acid metal salt, a Lewis acid, and an amine complex salt. Among them, an imidazole compound, a phosphorus-based compound, and a tertiary amine compound are preferably used, and particularly in the case of use for a semiconductor encapsulation material application, in point of the excellent curing property, heat resistance, electrical characteristics, and moisture resistance reliability, triphenylphosphin among the phosphorus compounds, and 1,8-diazabicyclo-[5.4.0]-undecene (DBU) among the tert-amines are preferred.

In the epoxy resin composition for electronic material of the present invention, as an epoxy resin component, the aforementioned polyfunctional biphenyl type epoxy resin represented by the formula (1) that is a triglycidyloxybiphenyl or a tetraglycidyloxybiphenyl may be used alone, but another epoxy resin may be used together to the extent that does not impair the effects of the present invention. Specifically, the other epoxy resin may be used together in such a range that the aforementioned epoxy resin accounts for 30% by mass or more, preferably 40% by mass or more based on the total mass of the epoxy resin components.

Here, as the other epoxy resin that can be used in combination with the aforementioned polyfunctional biphenyl type epoxy resin represented by the formula (1) that is a triglycidyloxybiphenyl or a tetraglycidyloxybiphenyl, various epoxy resins may be used, and examples thereof include bisphenol type epoxy resins such as a bisphenol A type epoxy resin and a bisphenol F type epoxy resin; benzene type epoxy resins such as a resorcinol diglycidyl ether type epoxy resin and a hydroquinone diglycidyl ether type epoxy resin; biphenyl type epoxy resins such as a tetramethylbiphenol type epoxy resin and a biphenol type epoxy resin; naphthalene type epoxy resins such as a 1,6-diglycidyloxynaphthalene type epoxy resin, 1-(2,7-diglycidyloxynaphthyl)-1-(2-glycidyloxynaphthyl)methane, 1,1-bis(2,7-diglycidyloxynaphthyl)methane, 1,1-bis(2,7-diglycidyloxynaphthyl)-1-phenyl-methane, and 1,1-bi(2,7-diglycidyloxynaphthyl); novolac type epoxy resins such as a phenol novolac type epoxy resin, a cresol novolac type epoxy resin, a bisphenol A novolac type epoxy resin, an epoxidized product of a condensate of a phenol and an aromatic aldehyde having a phenolic hydroxy group, a biphenyl novolac type epoxy resin, a naphthol novolac type epoxy resin, a naphthol-phenol co-condensed novolac type epoxy resin, and a naphthol-cresol co-condensed novolac type epoxy resin; aralkyl type epoxy resins such as a phenol aralkyl type epoxy resin and a naphthol aralkyl type epoxy resin; triphenylmethane type epoxy resins; tetraphenylethane type epoxy resins; dicyclopentadiene-phenol addition reaction type epoxy resins; phosphorus-containing epoxy resins synthesized by using 10-(2,5-dihydroxyphenyl)-10H-9-oxa-10-phosphaphenanthrene-10-oxide, etc. ; fluorene type epoxy resins; xanthene type epoxy resins; aliphatic epoxy resins such as neopentyl glycol diglycidyl ether and 1,6-hexanediol diglycidyl ether; alicyclic epoxy resins such as 3,4-epoxycyclohexylmethyl-3,4-epoxycyclohexanecarboxylate and bis-(3,4-epoxycyclohexyl)adipate; hetero ring-containing epoxy resins such as triglycidyl isocyanurate; glycidyl ester type epoxy resins such as phthalic acid diglycidyl ester, tetrahydrophthalic acid diglycidyl ester, hexahydrophthalic acid diglycidyl ester, diglycidyl p-hydroxybenzoic acid, a dimer acid glycidyl ester, and a triglycidyl ester; glycidylamine type epoxy resins such as diglycidylaniline, tetraglycidylaminodiphenylmethane, triglycidyl-p-aminophenol, tetraglycidyl-m-xylylenediamine, diglycidyltoluidine, and tetraglycidylbisaminomethylcyclohexane; and hydantoin type epoxy resins such as diglycidylhydantoin and glycidylglycidoxyalkylhydantoin. These epoxy resins each may be used alone, or two or more thereof may be mixed.

The epoxy composition for electronic material of the present invention further contains a filler as defined in claim 1. The filler used herein is preferably an inorganic filler, and such a filler can impart characteristics such as enhanced heat resistance, flame retardancy, lowered coefficient of linear expansion, and lowered permittivity to a resin composition. In particular, by using an inorganic filler having high thermal conductivity, the thermal conductivity of the epoxy resin composition for electronic material of the present invention is further enhanced.

As a filler used in the epoxy resin composition for electronic material of the present invention, for enhancing heat resistance, imparting flame retardancy, lowering permittivity, and lowering coefficient of linear expansion, various fillers such as fused silica, crystal silica, alumina, silicon nitride, and aluminum hydroxide are used. As a filler used for a semiconductor encapsulation material, a silica is preferably used, and then the heat resistance can be enhanced and the coefficient of linear expansion can be lowered. Examples of the silica include fused silica and crystal silica. When the filler is incorporated in an especially large amount, a fused silica is preferably used. The fused silica may be used in any shape of flake and sphere, but for increasing the amount of the spherical silica incorporated and suppressing increase of the melt viscosity of the molding material, it is preferred that the fused silica in a sphere shape is mainly used. For further increasing the amount of the fused silica incorporated, it is preferred that the particle size distribution of the spherical silica is appropriately adjusted. The filling rate thereof is preferably higher in view of the flame retardancy, and the filling rate is particularly preferably 65% by mass or more based on the total amount of the epoxy resin composition for electronic material. In addition, in the case of use for an electronic circuit board and the like, aluminum hydroxide is preferably used for imparting flame retardancy.

More specifically, in the epoxy resin composition for electronic material of the present invention, a thermal conductive filler is used for further enhancing the thermal conductivity. As the thermal conductive filler, a commonly known metallic filler, an inorganic compound filler, a carbonaceous filler, and the like may be used. Specific examples thereof include metallic fillers such as silver, copper, aluminum, iron, and stainless steel, and inorganic fillers such as alumina, magnesia, beryllia, silica, boron nitride, aluminum nitride, silicon nitride, silicon carbide, boron carbide, and titanium carbide, and carbonaceous fillers such as diamond, black lead, graphite, and carbon fiber. At least one kind of thermal conductive filler is selected and used, and it is possible that one kind or plural kinds of thermal conductive fillers having different crystal shape, particle size, and the like are used in combination. In the case where heat dissipating property is required in an application of electronic device and the like, electrical insulation is often required, and among these fillers, at least one kind of insulating thermal conductive filler selected from alumina, magnesium oxide, zinc oxide, beryllia, boron nitride, aluminum nitride, silicon nitride, and diamond which have both the high thermal conductivity and high volume resistivity is preferably used. The amount of the thermal conductive filler filled in the epoxy resin composition for electronic material has a limitation, and when the amount filled is too large, physical properties, such as, for example, adhesiveness in the case of use as a thermal conductive adhesive, are deteriorated, and therefore a thermal conductive filler having high thermal conductivity is used, that is, a thermal conductive filler of 10 W/m/K or higher is used. Among them, alumina, aluminum nitride, boron nitride, silicon nitride, and magnesium oxide are preferred in point of ensuring thermal conductivity and insulation, and in particular, alumina is more preferred, since in addition to the thermal conductivity and the insulation, the filling property into a resin is enhanced.

More specifically, as the thermal conductive filler, a filler which has been subjected to a surface treatment is used. In particular, the inorganic filler and the like is used after being subjected to surface-modification with a silane-based coupling agent.

The average particle size of the thermal conductive filler is not particularly limited, but a preferred lower limit is 0.2 µm and a preferred upper limit is 50 µm. When the average particle size of the thermal conductive filler is less than 0.2 µm, the viscosity of the epoxy resin composition for electronic material is increased and the workability and the like may be lowered. When the thermal conductive filler having an average particle size exceeding 50 µm is used in a large amount, the adhesive force between a cured product of the epoxy resin composition for electronic material and a substrate is short and a warp of an electronic component may be increased, a crack or peeling may occur under a hot-cold cycle or the like, or a peeling may occur at an adhesive interface. A more preferred lower limit of the average particle size of the thermal conductive filler is 0.4 µm and a more preferred upper limit thereof is 30 µm.

The shape of the thermal conductive filler is not limited, but from the viewpoint of the flowability of the epoxy resin composition for electronic material, the shape is preferably close to the sphere shape. For example, the aspect ratio (the ratio of the length of major axis of a particle relative to the length of minor axis of the particle (major axis/minor axis)) is not particularly limited, but a value closer to 1 is more preferred, and the ratio is preferably 1 to 80 and further preferably 1 to 10.

The content of the thermal conductive filler in the epoxy resin composition for electronic material is not particularly limited, and the thermal conductive filler is incorporated according to the thermal conductivity required in the application. The content of the thermal conductive filler is preferably 40 to 95 parts by weight in 100 parts by weight of the epoxy resin composition for electronic material. When the content of the thermal conductive filler is less than 40 parts by weight, a sufficient thermal conductivity of the epoxy resin composition for electronic material cannot be obtained. When the content of the thermal conductive filler exceeds 95 parts by weight, the adhesive force between a cured product of the epoxy resin composition for electronic material and a substrate is short and a warp of an electronic component is increased, a crack or peeling of an electronic component may occur under a hot-cold cycle or the like, or a peeling may occur at an adhesive interface. When the content of the thermal conductive filler exceeds 95 parts by weight, the viscosity of the epoxy resin composition for electronic material is increased and coating property, workability, and the like may be deteriorated. For effectively developing the functions of the thermal conductive filler to achieve high thermal conductivity, the thermal conductive filler is preferably filled in a higher level, and use in 60 to 90 parts by weight is preferred. In view of flowability of the epoxy resin composition, use in 60 to 85 parts by weight is more preferred.

As the thermal conductive filler, two or more kinds of different particle sizes are preferably used in mixture, whereby voids in a thermal conductive filler having a larger particle size are packed with a thermal conductive filler having a smaller particle size and thus the filler is filled more densely than in the case of using only a thermal conductive filler having a uniform particle size, and accordingly it is possible to exhibit higher thermal conductivity. Specifically, in the case of using alumina, when in the thermal conductive filler, one having an average particle size of 5 to 20 µm (a larger particle size) and another having an average particle size of 0.4 to 1.0 µm (a smaller particle size) are mixed in a ratio in the range of 45 to 75 % by weight and 25 to 55% by weight, respectively, the temperature dependency of the thermal conductivity is lowered and therefore such the ratio is preferred.

The epoxy resin composition for electronic material of the present invention may further contain a fibrous base material. By adding the fibrous base material, strength and low coefficient of linear expansion can be imparted to the resin composition for electronic material of the present invention, making it possible to suitably use the resin composition as a fiber-reinforced resin. Here, the fibrous base material used may be, for example, a plant fiber, a glass fiber, a carbon fiber, an aramid fiber, etc. and the fiber may be in a woven form, a nonwoven form, an aggregate of fibers, or a dispersion. Specific examples of the fibrous base material include a paper, a glass fabric, a glass nonwoven fabric, an aramid paper, an aramid fabric, an aramid nonwoven fabric, a glass mat, and a glass roving cloth, and when used as an electronic circuit board, glass fiber is preferred since strength and low coefficient of linear expansion can be imparted. For example, when a glass fiber is used to produce a prepreg, from the viewpoint of the flowability of the resin (impregnating property), preferred is a glass fabric which has a diameter of glass fibers of 10 µm or less and a fiber density of 40 to 80 fibers/inch and which has been treated with a silane coupling agent such as an epoxysilane coupling agent and an aminosilane coupling agent. A glass fabric which has been subjected to a treatment for eliminating voids in the net of warps and wefts as far as possible is further suitably used. As the glass nonwoven fabric, one having a basis weight of 15 g/m² and a thickness of about 0.1 mm to a basis weight of 120 g/m² and a thickness of about 1.0 mm is preferred. Incidentally, the fibrous base material for use in the present invention preferably has a thickness of 100 µm or less from the viewpoint of the use purpose.

Furthermore, as the filler in the present invention, a filler which has been subjected to a surface treatment is used. In particular, as the inorganic filler and the like, a filler which has been subjected to surface modification by a silane-based is used. From the viewpoint of flowability of the epoxy resin composition for electronic material, use of a filler treated with the coupling agent is advantageous in many cases. For example, by the surface treatment, adhesion between a resin and a filler in a cured product is further increased. For example, in the case of a thermal conductive filler, interfacial thermal resistance between the resin and the thermal conductive filler is decreased, whereby the thermal conductivity is increased.

As the coupling agent, a silane-based coupling agent is used, and examples of the silane coupling agent include vinyltrichlorosilane, vinyltriethoxysilane, vinyltrimethoxysilane, γ-methacryloxypropyltrimethoxysilane, β(3,4epoxycyclohexyl)ethyltrimethoxysilane, γ-glycidoxypropyltrimethoxysilane, γ-glycidoxymethoxypropylmethyldiethoxysilane, N-β(aminoethyl)γ-aminopropyltrimethoxysilane, N-β(aminoethyl)γ-aminopropylmethyldimethoxysilane, γ-aminopropyltriethoxysilane, N-phenyl-γ-aminopropyltrimethoxysilane, γ-mercaptopropyltrimethoxysilane, and γ-chloropropyltrimethoxysilane.

The surface treatment may be performed by a commonly known surface modification method for filler, and, for example, a spray technique using a fluid nozzle, a dry method by stirring accompanied by a shearing force, a ball mill, a mixer, or the like, or a wet method in an aqueous system, an organic solvent system, or the like may be adopted. A surface treatment using a shearing force is desirably performed in a manner that the shearing force is used to the extent that does not cause destruction of the filler.

The temperature in the system in the dry method or the drying temperature after a treatment in the wet method is appropriately determined according to the kind of the surface treating agent in the range where thermal decomposition is not caused. For example, in the case of being treated with γ-aminopropyltriethoxysilane, a temperature of 80 to 150°C is desirable.

The epoxy resin composition for electronic material of the present invention is characterized by exhibiting excellent solvent solubility. Accordingly, in the epoxy resin composition for electronic material of the present invention, an organic solvent may be incorporated. The organic solvent usable here is not particularly limited, and examples thereof include methyl ethyl ketone, acetone, dimethylformamide, methyl isobutyl ketone, methoxypropanol, cyclohexanone, methylcellosolve, ethyl diglycol acetate, and propylene glycol monomethyl ether acetate, and the selection of the kind of the solvent and an appropriate use amount thereof can be selected depending on the application. For example, in the printed wiring board application, a polar solvent having a boiling point of 160°C or lower such as methyl ethyl ketone, acetone, and dimethylformamide is preferred, and such a solvent is preferably used in a proportion of 40 to 80% by mass in terms of the non-volatile matter. On the other hand, in the application of adhesive film for buildup, as the organic solvent, for example, ketones such as acetone, methyl ethyl ketone, and cyclohexanone, acetic acid esters such as ethyl acetate, butyl acetate, cellosolve acetate, propylene glycol monomethyl ether acetate, and carbitol acetate, cellosolve, carbitols such as butylcarbitol, aromatic hydrocarbons such as toluene and xylene, amides such as dimethylformamide, dimethylacetamide, N-methylpyrrolidone, and the like are preferably used. In addition, the solvent is preferably used in a proportion of 30 to 60% by mass in terms of the non-volatile matter.

In addition, in the epoxy resin composition for electronic material of the present invention, for example, in the field of electronic circuit board, a halogen-free type flame retardant containing substantially no halogen atom may be incorporated for exhibiting flame retardancy.

Examples of the halogen-free type flame retardant include a phosphorus-based flame retardant, a nitrogen-based flame retardant, a silicone-based flame retardant, an inorganic flame retardant, and an organic metal salt-based flame retardant. The use thereof is by no means limited, and the flame retardants each may be used alone, plural flame retardants of the same type may be used, or flame retardants of different types may be used in combination.

The phosphorus-based flame retardant used may be an inorganic or organic compound. Examples of the inorganic compound include red phosphorus, ammonium phosphate compounds such as monoammonium phosphate, diammonium phosphate, triammonium phosphate, and ammonium polyphosphate, and an inorganic nitrogen-containing phosphorus compound such as phosphoric amide.

Examples of the organic phosphorus-based compound include a general-purpose organic phosphorus-based compound, such as a phosphoric acid ester compound, a phosphonic acid compound, a phosphinic acid compound, a phosphine oxide compound, a phosphorane compound, and an organic nitrogen-containing phosphorus compound, as well as a cyclic organic phosphorus compound, such as 9,10-dihydro-9-oxa-10-phosphaphenanthrene=10-oxide, 10-(2,5-dihydroxyphenyl)-10H-9-oxa-10-phosphaphenanthrene=10-oxide, and 10-(2,7-dihydroxynaphthyl)-10H-9-oxa-10-phosphaphenanthrene=10-oxide, and a derivative obtained by reacting the above compound with a compound such as an epoxy resin and a phenol resin.

The amount of the phosphorus-based flame retardant incorporated is appropriately selected depending on the kind of the phosphorus-based flame retardant, other components in the curable resin composition, and the desired degree of the flame retardancy. For example, relative to the epoxy resin composition for electronic material in which all of the epoxy resin, the curing agent, the halogen-free type flame retardant, and other fillers, additives, and the like are blended, in the case of using red phosphorus as the halogen-free type flame retardant, red phosphorus is preferably incorporated in the range of 0.1 to 2.0% by mass, and in the case of using an organic phosphoric compound, the organic phosphoric compound is preferably incorporated in the range of 0.1 to 10.0% by mass, and particularly preferably in the range of 0.5 to 6.0% by mass.

In the case of using the phosphorus-based flame retardant, hydrotalcite, magnesium hydroxide, a boron compound, zirconium oxide, a black dye, calcium carbonate, zeolite, zinc molybdate, activated carbon, etc. may be used in combination with the phosphorus-based flame retardant.

Examples of the nitrogen-based flame retardant include a triazine compound, a cyanuric acid compound, an isocyanuric acid compound, and a phenothiazine, and a triazine compound, a cyanuric acid compound, and an isocyanuric acid compound are preferred.

Examples of the triazine compound include melamine, acetoguanamine, benzoguanamine, melon, melam, succinoguanamine, ethylenedimelamine, melamine polyphosphate, and triguanamine, as well as, for example, (i) an aminotriazine sulfate compound such as guanyl melamine sulfate, melem sulfate, and melam sulfate, (ii) a co-condensate of a phenol compound such as phenol, cresol, xylenol, butylphenol, and nonylphenol, a mealmine compound such as melamine, benzoguanamine, acetoguanamine, and formguanamine, and formaldehyde, (iii) a mixture of the co-condensate of the above (ii) and a phenol resin such as a phenol-formaldehyde condensate, and (iv) a compound obtained by further modifying the above (ii) or (iii) with tung oil or an isomerized linseed oil.

Specific examples of the cyanuric acid compound include cyanuric acid and melamine cyanurate.

The amount of the nitrogen-based flame retardant incorporated is appropriately selected depending on the kind of the nitrogen-based flame retardant, other components of the curable resin composition, and the desired degree of the flame retardancy. For example, relative to the epoxy resin composition for electronic material in which all of the epoxy resin, the curing agent, the halogen-free type flame retardant, and other fillers, additives, and the like are blended, the nitrogen-based flame retardant is preferably incorporated in the range of 0.05 to 10% by mass, and particularly preferably incorporated in the range of 0.1 to 5% by mass.

In the case of using the nitrogen-based flame retardant, a metal hydroxide, a molybdenum compound, or the like may be used together.

The silicone-based flame retardant can be used without any particular limitation as long as it is an organic compound containing a silicon atom, and examples thereof include a silicone oil, a silicone rubber, and a silicone resin.

The amount of the silicone-based flame retardant incorporated is appropriately selected depending on the kind of the silicone-based flame retardant, other components of the epoxy resin composition for electronic material, and the desired degree of the flame retardancy. For example, relative to the epoxy resin composition for electronic material in which all of the epoxy resin composition for electronic material, the halogen-free type flame retardant, and other fillers, additives, and the like are blended, the silicone-based flame retardant is preferably incorporated in the range of 0.05 to 20% by mass. In the case of using the silicone-based flame retardant, a molybdenum compound, an alumina, or the like may be used together.

Examples of the inorganic flame retardant include a metal hydroxide, a metal oxide, a metal carbonate compound, a metal powder, a boron compound, and a low-melting glass.

Specific examples of the metal hydroxide include aluminum hydroxide, magnesium hydroxide, dolomite, hydrotalcite, calcium hydroxide, barium hydroxide, and zirconium hydroxide.

Specific examples of the metal oxide include zinc molybdate, molybdenum trioxide, zinc stannate, tin oxide, aluminum oxide, iron oxide, titanium oxide, manganese oxide, zirconium oxide, zinc oxide, molybdenum oxide, cobalt oxide, bismuth oxide, chromium oxide, nickel oxide, copper oxide, and tungsten oxide.

Specific examples of the metal carbonate compound include zinc carbonate, magnesium carbonate, calcium carbonate, barium carbonate, basic magnesium carbonate, aluminum carbonate, iron carbonate, cobalt carbonate, and titanium carbonate.

Specific examples of the metal powder include aluminum, iron, titanium, manganese, zinc, molybdenum, cobalt, bismuth, chromium, nickel, copper, tungsten, and tin.

Specific examples of the boron compound include zinc borate, zinc metaborate, barium metaborate, boric acid, and borax.

Specific examples of the low-melting glass include Ceepree (Bokusui Brown), a hydrated glass SiO₂-MgO-H₂O, and a PbO-B₂O₃-based, ZnO-P₂O₅-MgO-based, P₂O₅-B₂O₃-PbO-MgO-based, P-Sn-O-F-based, PbO-V₂O₅-TeO₂-based, Al₂O₃-H₂O-based, and lead borosilicate-based glass compound.

The amount of the inorganic flame retardant incorporated is appropriately selected depending on the kind of the inorganic flame retardant, other components of the epoxy resin composition for electronic material, and the desired degree of the flame retardancy. For example, relative to the curable resin composition in which all of the epoxy resin composition for electronic material, the halogen-free type flame retardant, and other fillers, additives, and the like are blended, the inorganic flame retardant is preferably incorporated in the range of 0.5 to 50% by mass, and particularly preferably incorporated in the range of 5 to 30% by mass.

Examples of the organic metal salt-based flame retardant include ferrocene, an acetylacetonate metal complex, an organic metal carbonyl compound, an organic cobalt salt compound, an organic sulfonic acid metal salt, and a compound in which a metal atom and an aromatic compound or a heterocyclic compound are connected via an ionic bond or a coordinate bond.

The amount of the organic metal salt-based flame retardant incorporated is appropriately selected depending on the kind of the organic metal salt-based flame retardant, other components of the epoxy resin composition for electronic material, and the desired degree of the flame retardancy. For example, relative to the epoxy resin composition for electronic material in which all of the epoxy resin composition for electronic material, the halogen-free type flame retardant, and other fillers, additives, and the like are blended, the organic metal salt-based flame retardant is preferably incorporated in the range of 0.005 to 10% by mass.

In the epoxy resin composition for electronic material of the present invention, various compounding agents such as a coupling agent, a mold release agent, a pigment, and an emulsifier can be added, as required.

The epoxy resin composition for electronic material of the present invention can be obtained by uniformly mixing the compounds described above. The epoxy resin composition for electronic material of the present invention in which the epoxy resin represented by the formula (1) of the present invention and the curing agent or curing accelerator are blended can be easily made into a cured product by a method similar to a conventionally known method. As the cured product, molded cured products such as a laminated product, a casted product, an adhesive layer, a coating, and a film are exemplified.

The epoxy resin composition for electronic material of the present invention can be suitably used for a semiconductor encapsulation material, a material for an electronic circuit board, and the like. In particular, since the epoxy resin for electronic material of the present invention is excellent in thermal conductivity, the epoxy resin composition can be used particularly suitably for a heat dissipating material among the electronic materials, and particularly preferably used for a thermal conductive adhesive and the like.

### [Thermal conductive adhesive]

For example, in the case of use as a thermal conductivity adhesive, the epoxy resin composition for electronic material is used for developing good heat dissipating by bonding a portion of an electrical or electronic device where the heat is to be dissipated such as a power module with a heat dissipating component (for example, a metal plate or a heat sink). In this case, the form of the epoxy resin composition for electronic material used is not particularly limited, but in the case of the epoxy resin composition for electronic material that is designed to be a liquid or paste form, the epoxy resin composition for electronic material in a liquid or paste form may be injected into the interface of the bonding surface to adhere the components and then cured. In the case of the epoxy resin composition designed to be a solid form, the epoxy resin composition in a powder, chip, or sheet form may be placed at the interface of the bonding surface, subjected to thermal melting to adhere the components and then cured. In addition, the epoxy resin composition in a semi-cured state may be used as a thermal conductive adhesive. For example, the epoxy resin composition molded into a sheet form is semi-cured, then brought into contact with a component to be adhered and subjected to final curing, whereby the epoxy resin composition can be used as a thermal conductive adhesive.

### [Semiconductor encapsulation material]

For example, for producing the epoxy resin composition for electronic material used for a semiconductor encapsulation material, the polyfunctional biphenyl type epoxy resin that is a triglycidyloxybiphenyl or a tetraglycidyloxybiphenyl and the curing agent mentioned above are mixed sufficiently into a uniform mixture, using, for example, an extruder, a kneader, a roll, etc., whereby an epoxy resin composition for electronic material of a melt-mixing type may be obtained. In this case, as a filler, silica, alumina, silicon nitride, boron nitride, or aluminum nitride is used, and the filling rate is in the range of 30 to 95 parts by mass of the filler based on 100 parts by mass of the epoxy resin composition for electronic material. In particular, for enhancing flame retardancy, moisture resistance and solder crack resistance, and for lowering coefficient of linear expansion, the filling rate is preferably 65 parts by mass or more, particularly preferably 70 parts by mass or more, and for further enhancing the effects, a filling rate of 80 parts by mass or more can further enhance the effect.

As a semiconductor package molding, a method in which the composition is molded using a casting die, a transfer molding machine, an injection molding machine, or the like, and further heated at 50 to 200°C for 2 to 10 hours, thereby obtaining a semiconductor device which is a molded article, may be exemplified.

In the epoxy resin composition for electronic material used for in a semiconductor encapsulation material in the present invention, for enhancing the adhesiveness between a resin component and an inorganic filler, a coupling agent is used.

The amount of the coupling agent incorporated is preferably 0.01 to 5% by mass relative to the filler, and more preferably 0.05 to 2.5% by mass. With an amount less than 0.01% by mass, the adhesiveness with various package constituting components tends to decrease, and with an amount exceeding 5% by mass, molding failure such as a void tends to occur.

Furthermore, in the epoxy resin composition for electronic material used for a semiconductor encapsulation material of the present invention, as other additive, a mold release agent, a coloring agent, a stress relaxation agent, an adhesion enhancing agent, a surfactant, etc. may be incorporated as required.

Examples of the mold release agent include carnauba wax, and a hydrocarbon-based, an aliphatic-based, an amide-based, an ester-based, a higher alcohol-based, and a higher fatty acid metal salt-based compounds.

Examples of the hydrocarbon compound include a paraffin wax and a polyolefin-based wax. The polyolefin-based wax is roughly classified into a nonpolar polyolefin wax which is not oxidized and an oxidized polyolefin wax, and each thereof include a polyethylene-based, a polypropylene-based, and a vinyl acetate-ethylene copolymer-based compounds.

Examples of the fatty acid-based compound include Montanic acid, stearic acid, behenic acid, and 12-hydroxystearic acid. Examples of the amide-based compound include stearic acid amide, oleic acid amide, and methylene bisstearic acid amide. Examples of the ester-based compound include butyl stearate, stearic acid monoglyceride, and stearyl stearate. Examples of the higher alcohol-based compound include stearyl alcohol. Examples of the higher fatty acid metal salt include calcium stearate, zinc stearate, and magnesium stearate.

As the coloring agent, any of inorganic coloring agents such as red iron oxide, carbon black, and a glass composition, and pigments of a phthalocyanine-based compound, an anthraquinone-based, a methane-based, an indigoid-based, and an azo-based organic compounds can be used, but carbon black is preferred since it is excellent in the coloring effect.

The stress lowering agent (stress relaxation agent) is not particularly limited, and those described in a butadiene-based copolymer rubber such as a methyl acrylate-butadiene-styrene copolymer and a methyl methacrylate-butadiene-styrene copolymer and silicone-based compound, for example, a silicone oil, a liquid rubber, a rubber powder, a thermoplastic resin, and the like may be exemplified.

Furthermore, for the purpose of enhancing reliability in a moisture resistance reliability test, a hydrotalcite and an ion trapping agent such as bismuth hydroxide may be incorporated.

The adhesion enhancing agent is not particularly limited, and examples thereof include N-cyclohexyl-2-benzothiazolyl sulfanamide, N-oxydiethylene-2-benzothiazolyl sulfanamide, N,N-dicyclohexyl-2-benzothiazolyl sulfanamide, N-t-butyl-2-benzothiazolyl sulfanamide, a compound having a benzothiazole skeleton, an indene resin, a cross-linked diallylphthalate resin powder, and butadiene-based rubber particles.

Examples of the surfactant include a polyethylene glycol fatty acid ester, a sorbitan fatty acid ester, and a fatty acid monoglyceride.

The epoxy resin composition for electronic material used for a semiconductor encapsulation material of the present invention can be prepared using any techniques as long as the various raw materials can be uniformly dispersed and mixed, but as a general technique, a method in which prescribed blending amounts of raw materials are sufficiently mixed by a mixer or the like, and then the mixture is melt and kneaded by a mixing roll, an extruder, or the like, followed by cooling and pulverizing may be exemplified. It is convenient for use to form the resultant into a tablet having a size and a mass matching the molding conditions.

As an electronic component device provided with an element encapsulated with the epoxy resin composition for electronic material used for a semiconductor encapsulation material obtained in the present invention, an electronic component device in which elements, such as an active element, for example, a semiconductor chip, a transistor, a diode, and a thyristor, and a passive element, for example, a capacitor, a resistor, and a coil, are mounted on a support component, such as a lead frame, a prewired tape carrier, a wiring board, a glass, and a silicon wafer, and a necessary part are encapsulated with the semiconductor encapsulation material of the present invention, is exemplified. Specific examples of such an electronic component device include, 1) a general resin encapsulation type IC such as DIP, PLCC, QFP, SOP, SOJ, TSOP, and TQFP, in which semiconductor elements are fixed on a lead frame, terminal portions and lead portions of the elements such as a bonding pad are connected by wire bonding or bump, followed by encapsulating, for example, by transfer molding using the semiconductor encapsulation material of the present invention, 2) a semiconductor chip in which a semiconductor chip connected to a tape carrier with a bump is connected to a wire formed on a TCP, a wiring board, or a glass, which is encapsulated with the semiconductor encapsulation material of the present invention by wire bonding, flip chip bonding, solder, and the like, 3)a COB module in which an active element such as a transistor, a diode, and a thyristor or a passive element such as a capacitor, a resister, and a coil is encapsulated with the semiconductor encapsulation material of the present invention, 4) one surface-encapsulated package such as BGA, CSP, and MCP in which a semiconductor chip is mounted on an interposer substrate having a hybrid IC, a multichip module, and a terminal for connecting a mother board formed thereon, and the semiconductor chip and a wire formed on the interposer substrate are connected by bump or wire bonding, followed by encapsulating the semiconductor chip mounting side with the semiconductor encapsulation material of the present invention. Among other, the one surface-encapsulated type package provided with an element encapsulated with the epoxy resin composition for electronic material used for a semiconductor encapsulation material obtained in the present invention has a characteristic that the warping is small.

As the above lead frame, a lead frame of copper (including a copper alloy), a Ni-plated lead frame in which a Ni layer is formed on a surface of a copper plate or the like by a method such as plating, and a lead frame made of 42-alloy,may be used.

As a method for encapsulating an element using the epoxy resin composition for electronic material used for a semiconductor encapsulation material of the present invention, a low pressure transfer molding method is the most common method, but an injection molding method, a compaction molding method, and the like may be used.

### [Electronic circuit board]

The epoxy resin composition for electronic material used for an electronic circuit board of the present invention is specifically used for a printed wiring board material, a flexible wiring board material, an interlayer insulating material for buildup substrate, a conductive paste, an adhesive film material for buildup, a resist ink, a resin casting material, an adhesive, and the like. In addition, among the various applications, in the application of a printed wiring board, a flexible wiring board material, an interlayer insulating material for buildup substrate, and an adhesive film for buildup, the epoxy resin composition can be used as a so-called insulating material for a substrate for built-in electronic components in which a passive component such as a capacitor or an active component such as an IC chip is embedded in a substrate. Among them, from the viewpoints of the characteristics such as high flame retardancy, high heat resistance, low thermal expansion, and solvent solubility, use for a resin composition for flexible wiring board or an interlayer insulating material for buildup substrate is preferred.

Here, for producing a printed wiring board from the epoxy resin composition for electronic material of the present invention, a method in which in addition to the epoxy resin composition for electronic material, an organic solvent is blended to prepare an epoxy resin composition in a varnish form, a reinforced substrate is impregnated with the varnish, a copper foil is laminated, and the laminate is heated and pressed, may be exemplified. The reinforced substrate usable here is the fibrous base material of the present invention, and examples thereof include a paper, a glass fabric, a glass nonwoven fabric, an aramid paper, an aramid fabric, a glass mat, a glass roving cloth, or the like. The above method will be described in more detail. Firstly, the curable resin composition in a varnish form mentioned above is heated at a heating temperature according to the kind of the solvent used, preferably at 50 to 170°C to obtain a prepreg which is a cured product. The mass ratio of the resin composition and the fibrous base material used in this time is not particularly limited, but, in general, the prepreg is preferably prepared so that the resin content in the prepreg is 20 to 60% by mass. Subsequently, the prepreg obtained as the above is laminated by an ordinary method, and a copper foil is appropriately laminated, and the laminate is heated and pressed under a pressure of 1 to 10 MPa at 170 to 250°C for 10 minutes to 3 hours, whereby a target printed wiring board can be obtained.

For producing a flexible wiring board from the epoxy resin composition for electronic material of the present invention, in addition to the epoxy resin composition for electronic material, a phosphorus atom-containing compound, a curing accelerator, and an organic solvent are blended, and using a coating machine such as a reverse roll coater and a comma coater, the blend is applied on an electrical insulating film. Subsequently, the solvent is vaporized by heating with a heater at 60 to 170°C for 1 to 15 minutes to bring the adhesive composition into a B-stage. Then, using a heat roll and the like, a metal foil is heat-pressed on the adhesive. The pressure for the press at that time is preferably 2 to 200 N/cm, and the temperature for the press is preferably 40 to 200°C. When sufficient performance of adhesion can be obtained, the press may be finished here, but when complete curing is needed, post-curing is preferably performed under conditions of 100 to 200°C and 1 to 24 hours. The final thickness of the adhesive composition film after curing is preferably in the range of 5 to 100 µm.

As a method for obtaining an interlayer insulating material for buildup substrate from the epoxy resin composition for electronic material of the present invention, for example, in addition to the epoxy resin composition for electronic material, a rubber, a filler, etc. are appropriately blended, and the blend was applied on a wiring board having a circuit formed thereon using a spray coating method, a curtain coating method, and the like, and then cured. Subsequently, after performing perforation of a prescribed through hole portion and the like as required, the resultant is treated with a roughening agent, and the surface is washed with hot water, thereby forming roughness on the substrate, followed by subjecting the surface to a plating treatment by a metal such as copper. As the plating method, an electroless plating and an electroplating treatment are preferred, and as the roughening agent, an oxidant, an alkali, an organic solvent, and the like are exemplified. Such an operation is sequentially repeated as desired, and resin insulating layers and conductive layers having a prescribed circuit pattern are formed while alternately building up the layers, whereby a buildup board can be obtained. However, the perforation of the through hole portion is performed after formation of the outermost resin insulating layer. Alternatively, it is possible to produce the buildup substrate by heating and pressing a copper foil with resin in which the resin composition is semi-cured on a copper foil, at 170 to 250°C on a circuit board having a circuit formed thereon, with the steps of the roughened surface formation and the plating treatment omitted.

As a method for producing an adhesive film for buildup from the epoxy resin composition for electronic material of the present invention, for example, a method in which in addition to the epoxy resin composition for electronic material, an organic solvent is blended to prepare an epoxy resin composition in a varnish form, the varnish is applied on a support film to form a resin composition layer, thereby producing an adhesive film for a multilayer printed wiring board, may be exemplified.

When the epoxy resin composition for electronic material of the present invention is used for the adhesive film for buildup, it is important that the adhesive film is softened at a temperature condition of lamination in a vacuum lamination method (generally from 70°C to 140°C) to achieve a flowability (resin flow) that allows for the resin to fill in a via hole or a through hole which is present in the circuit board, at the same time with the lamination of the circuit board. The components are preferably blended so as to exhibit such characteristic.

Here, the through hole in the multilayer printed wiring board generally has a diameter of 0.1 to 0.5 mm and generally has a depth of 0.1 to 1.2 mm, and in general the resin is preferably allowed to fill in the hole in the above range. Incidentally, when both the surfaces of the circuit board are laminated, it is desired that about one-half of the through hole is filled.

As a method for producing the adhesive film, specifically, a method in which the epoxy resin composition for electronic material in a varnish form is applied on a surface of a support film, and the organic solvent is dried, for example, by heat or blowing with hot blast to form a layer of the epoxy resin composition, may be exemplified.

The thickness of the layer formed is generally the thickness of the conductor layer or more. The thickness of the conductor layer included in the circuit board is generally in the range of 5 to 70 µm, and therefore the resin composition layer preferably has a thickness of 10 to 100 µm.

Incidentally, the layer may be protected by a protection film described later. By protecting the layer with a protection film, it is possible to prevent deposition of dust and scratches on the surface of the resin composition layer.

Examples of the support film and protection film include polyolefins such as polyethylene, polypropylene, and polyvinyl chloride, polyesters such as polyethylene terephthalate (hereinunder, sometimes abbreviated as "PET") and polyethylene naphthalate, polycarbonate, and polyimide, and further include a release paper and a metal foil such as copper foil and aluminum foil. Incidentally, the support film and protection film may be previously subjected to a mud treatment, a corona treatment, as well as a mold release treatment.

The thickness of the support film is not particularly limited, but generally 10 to 150 µm, and preferably in the range of 25 to 50 µm. The thickness of the protection film is preferably 1 to 40 µm.

The support film is released after lamination on the circuit board, or after thermal curing to form an insulating layer. By releasing the support film after the adhesive film is thermally cured, deposition of dust and the like in the curing step can be prevented. In the case of releasing after curing, in general, the support film is previously subjected to a mold release treatment.

Next, as for a method for producing a multilayer printed wiring board using the adhesive film obtained as the above, for example, after releasing a protection film in the case where the layer is protected by the protection film, the layer is laminated on one or both surfaces of the circuit board in direct contact with the circuit board, for example, by a vacuum lamination method. The lamination method may be a batch process, or may be a continuous process by a roll. In addition, the adhesive film and the circuit board may be heated (preheated) before the lamination as required.

As the condition of the lamination, the pressing temperature (lamination temperature) is preferably 70 to 140°C, the pressing pressure is preferably 1 to 11 kgf/cm² (9.8 × 10⁴ to 107.9×10⁴ N/m²), and the lamination is preferably performed under a reduced air pressure of 20 mmHg (26.7 hPa) or lower.

When the epoxy resin composition for electronic material of the present invention is used as a conductive paste, for example, a method in which fine conductive particles are dispersed in the curable resin composition to prepare a composition for anisotropic conductive film, or to prepare a paste resin composition for circuit connection or an anisotropic conductive adhesive which is in a liquid form at room temperature, may be exemplified.

When the epoxy resin composition for electronic material of the present invention is used as a resist ink, for example, a method in which a cationic polymerization catalyst is used as a catalyst for the epoxy resin composition, a pigment, talk, and a filler are further added to prepare a composition for resist ink, and then the composition is applied on a printed board by a screen printing technique, followed by curing into a resist ink cured product, may be exemplified.

The method for obtaining a cured product from the epoxy resin composition for electronic material of the present invention may be based on a general curing method of a curable resin composition. For example, the heating temperature condition may be appropriately selected depending on the kind of the curing agent combined and the use purpose, but the composition obtained by the above method may be heated in the temperature range of approximately from a room temperature to 250°C.

Thus, by using the epoxy resin, the epoxy resin composition for electronic material has a low viscosity and is good in solvent solubility, and a cured product thereof exhibits an extremely excellent heat resistance, high thermal conductivity, and low thermal expansion. Accordingly, the epoxy resin can be suitably used in the electronic material application in which high temperature stability and high heat dissipating property are required, in particular for a heat dissipating material, and can be suitably used for a thermal conductive adhesive, an encapsulation material of a high performance semiconductor, and an electronic circuit board material.

### Examples

The present invention will be specifically described with reference to examples and comparative examples. "Examples" 1 to 3 are for reference and/or comparison only. Incidentally, a melt viscosity at 150°C and a melting point, and GPC were measured under the following conditions.
1) Melt viscosity at 150°C: measured by the following apparatus according to ASTM D4287.
   Apparatus name: MODEL CV-1S manufactured by Codex
2) Melting point: measured using a thermogravimetry-differential thermal analyzer (TG/DTA6200 manufactured by Hitachi High-Tech Science Corporation).

### Measurement conditions

Measurement temperature: room temperature to 300°C
Measurement atmosphere: nitrogen
Temperature rising rate: 10°C/min

3) GPC: measurement conditions were as follows.
Measurement apparatus: "Shodex GPC-104" manufactured by Showa Denko K. K.
Column: "Shodex KF-401HQ" manufactured by Showa Denko K. K.
   + "Shodex KF-401HQ" manufactured by Showa Denko K. K.
   + "Shodex KF-402HQ" manufactured by Showa Denko K. K.
   + "Shodex KF-402HQ" manufactured by Showa Denko K. K.
Detector: RI(refractive index detector)
Data processor: "Empower 2" manufactured by Waters Corporation
Measurement conditions: column temperature: 40°C
Mobile phase: tetrahydrofuran
Flow rate: 1.0 ml/min
Standard: (polystyrene used)

"Polystyrene Standard 400" manufactured by Waters Corporation

"Polystyrene Standard 530" manufactured by Waters Corporation

"Polystyrene Standard 950" manufactured by Waters Corporation

"Polystyrene Standard 2800" manufactured by Waters Corporation

Sample: obtained by filtering a 1.0 mass% tetrahydrofuran solution in terms of the resin solid through a microfilter (50 µl).

### [Synthesis Example 1]

### (Synthesis of 2,4,4'-triglycidyloxybiphenyl)

In a flask equipped with a thermometer, a dropping funnel, a condenser tube, and a stirrer, while being purged with nitrogen gas, 43 g of 2,4,4'-trihydroxybiphenyl, 295 g of epichlorohydrin, and 103 g of n-butanol were charged and dissolved. After the temperature was raised to 40°C, 53 g of a 48% by mass sodium hydroxide aqueous solution was added over 8 hours. The temperature was then further raised to 50°C, and the mixture was allowed to react for further 1 hour. After the completion of the reaction, 83 g of water was added, the mixture was allowed to stand, and then the lower layer was disposed. After that, unreacted epichlorohydrin was removed by distillation at 150°C under reduced pressure. To the obtained crude epoxy resin, 118 g of methyl isobutyl ketone was added to dissolve the epoxy resin. To the solution, 67 g of a 10% by mass sodium hydroxide aqueous solution was further added, the mixture was allowed to react at 80°C for 2 hours, and then washing with water was repeated three times until the pH of the washing liquid became neutral. Next, the system was dehydrated by azeotropic distillation, and subjected to microfiltration, followed by removing the solvent by distillation under reduced pressure, whereby 63 g of 2,4,4'-triglycidyloxybiphenyl (A-1) which was the target epoxy resin was obtained. The obtained epoxy resin (A-1) was in a liquid form of 943 Pa·s, and had a melt viscosity (measurement method: ICI viscometer method, measurement temperature: 150°C) of 0.14 dPa·s, and an epoxy equivalent of 131 g/eq. From a GPC measurement, the target product accounted for 80% or more in terms of area ratio, and from a MS measurement, a peak of 370 indicating 2,4,4'-triglycidyloxybiphenyl (A-1) was confirmed.

### [Synthesis Example 2]

### (Synthesis of 3,4',5-triglycidyloxybiphenyl)

In a flask equipped with a thermometer, a dropping funnel, a condenser tube, and a stirrer, while being purged with nitrogen gas, 43 g of 3,4',5-trihydroxybiphenyl, 295 g of epichlorohydrin, and 103 g of n-butanol were charged and dissolved. After the temperature was raised to 40°C, 53 g of a 48% by mass sodium hydroxide aqueous solution was added over 8 hours, then the temperature was further raised to 50°C, and the mixture was allowed to react for further 1 hour. After the completion of the reaction, 83 g of water was added, the mixture was allowed to stand, and then the lower layer was disposed. After that, unreacted epichlorohydrin was removed by distillation at 150°C under reduced pressure. To the obtained crude epoxy resin, 118 g of methyl isobutyl ketone was added to dissolve the epoxy resin. To the solution, 67 g of a 10% by mass sodium hydroxide aqueous solution was further added, the mixture was allowed to react at 80°C for 2 hours, and then washing with water was repeated three times until the pH of the washing liquid became neutral. Next, the system was dehydrated by azeotropic distillation, and subjected to microfiltration, followed by removing the solvent by distillation under reduced pressure, whereby 62 g of 3,4',5-triglycidyloxybiphenyl (A-2) which was the target epoxy resin was obtained. The obtained epoxy resin (A-2) was a crystal having a melting point of 97°C at room temperature, and had a melt viscosity (measurement method: ICI viscometer method, measurement temperature: 150°C) of 0.27 dPa·s, and an epoxy equivalent of 135 g/eq. From a GPC measurement, the target product accounted for 79% or more in terms of area ratio, and from a MS spectrum, a peak of 370 indicating 3,4',5-triglycidyloxybiphenyl (A-2) was detected.

### [Synthesis Example 3]

### (Synthesis of 3,3',5,5'-tetraglycidyloxybiphenyl)

In a flask equipped with a thermometer, a dropping funnel, a condenser tube, and a stirrer, while being purged with nitrogen gas, 35 g of 3,3',5,5'-tetrahydroxybiphenyl, 297 g of epichlorohydrin, 104 g of n-butanol were charged and dissolved. After the temperature was raised to 40°C, 53 g of a 48% sodium hydroxide aqueous solution was added over 8 hours, the temperature was then further raised to 50°C and the mixture was further reacted for 1 hour. After the completion of the reaction, 84 g of water was added, the mixture was allowed to stand, and then the lower layer was disposed. After that, unreacted epichlorohydrin was removed by distillation at 150°C under reduced pressure. To the obtained crude epoxy resin, 106 g of methyl isobutyl ketone was added to dissolve the epoxy resin. To the solution, 67 g of a 10 mass% sodium hydroxide aqueous solution was further added, the mixture was allowed to react at 80°C for 2 hours, and then washing with water was repeated three times until the pH of the washing liquid became neutral. Next, the system was dehydrated by azeotropic distillation, and subjected to microfiltration, followed by removing the solvent by distillation under reduced pressure, whereby 60 g of 3,3',5,5'-tetraglycidyloxybiphenyl(A-3) which was the target epoxy resin was obtained. The obtained epoxy resin (A-3) was a solid having a melting point of 115°C, and had a melt viscosity (measurement method: ICI viscometer method, measurement temperature: 150°C) of 0.57 dPa·s, and an epoxy equivalent of 121 g/eq. From a GPC measurement, the target product accounted for 78% or more in terms of area ratio, and from a MS spectrum, a peak of 442 indicating 3,3',5,5'-tetraglycidyloxybiphenyl (A-3) was confirmed.

### [Examples 1 to 3 and Comparative Examples 1 to 2]

Using the epoxy resins (A-1, A-2, A-3) of the present invention obtained in Synthesis Examples 1 to 3, and 3,3',5,5'-tetramethyl-4,4'-biphenol type epoxy resin (A-4) as a comparative epoxy resin, and using imidazole (2E4MZ (manufactured by Shikoku Chemicals Corporation)) as a curing accelerator, the components were blended in compositions shown in Table 1, each blend was poured into a mold frame of 6 cm × 11 cm × 0.8 mm, and temporally cured at a temperature of 110°C for 2 hours. Subsequently, the molded article was removed from the mold frame and then cured at a temperature of 250°C for 2 hours, whereby a cured product was produced. In addition, using a naphthalene type tetrafunctional epoxy resin, HP-4700 (manufactured by DIC Corporation) (A-5), and using imidazole (2PHZ-PW (manufactured by Shikoku Chemicals Corporation)) as a curing accelerator, the components were blended in compositions shown in Table 1, the blend was poured into a mold frame of 6 cm × 11 cm × 0.8 mm, and cured at a temperature of 170°C for 2 hours, whereby a cured product was produced. For the obtained cured product, the heat resistance, coefficient of linear expansion, and thermal conductivity were evaluated. In addition, the solvent solubilities of the epoxy resins (A-1, A-2, A-3) of the present invention and the comparative epoxy resins (A-4, A-5) were measured by the following method. The results are shown in Table 1.

### <Heat resistance (glass transition temperature)>

Heat resistance was evaluated using a viscoelasticity measurement apparatus (DMA: Solid viscoelasticity measurement apparatus RSAII, manufactured by Rheometric, rectangular tension method: frequency 3.5Hz, temperature rising rate 3°C/min), with the temperature at which change in viscoelasticity was maximum (the rate of change in tan δ was maximum) taken as the glass transition temperature.

### <Heat resistance (5% weight reduction temperature)>

Using a thermogravimetry-differential thermal analyzer (TG/DTA6200 manufactured by SII Nanotechnology), a resin coating was weighed into an aluminum pan container, the temperature was raised from a room temperature to 500°C, and the 5% weight reduction temperature was measured.

### Measurement conditions

Measurement temperature: room temperature to 500°C
Measurement atmosphere: nitrogen
Temperature rising rate: 10°C/min

### <Coefficient of linear expansion>

Using a thermal mechanical analyzer (TMA: TMA-50 manufactured by Shimadzu Corporation), a thermal mechanical analysis was performed in a tension mode.

### Measurement conditions

Load: 1.5 g
Temperature rising rate: 10°C/min × twice
Measurement temperature range: 50°C to 300°C

Measurement under the above conditions was performed twice for one sample, and the mean coefficient of linear expansion in the temperature range of 25°C to 280°C in the second measurement was evaluated as the coefficient of linear expansion.

### <Thermal conductivity>

Thermal conductivity (λ) was calculated based on the formula: λ = αρC using a specific gravity (ρ), a thermal diffusion factor (α), and a specific heat capacity (C). The specific gravity, thermal diffusion factor and specific heat capacity were obtained by the following methods.

### (1) Specific gravity

A specific gravity was measured using an electronic balance CP224S and a specific gravity measurement kit YDK01CP (manufactured by Sartorius).

### (2) Thermal diffusion factor

A thermal diffusion factor at 25°C was measured using a thermal diffusivity measurement apparatus LFA447 Nanoflash (manufactured by NETZSCH).

### (3) Specific heat capacity

A specific heat capacity at 25°C was calculated using a differential scanning calorimeter EXSTAR7200 (manufactured by Hitachi High-Tech Science Corporation).

### Measurement condition

Measurement temperature: -20 to 100°C
Measurement atmosphere: Nitrogen
Temperature rising rate: 10°C/min

### <Solvent solubility >

In a sample bottle, 10 parts of an epoxy resin and 4.3 parts of methyl ethyl ketone were dissolved at 60°C in a sealed state. After that, the mixture was cooled to 25°C, and evaluated whether or not crystals were precipitated. The case where no crystal precipitated was rated as "A", and the case where crystals precipitated was rated as "B".

**[Table 1]**

| | | Example 1^{*2} | Example 2^{*2} | Example 3^{*2} | Comparative Example 1 | Comparative Example 2 |
|---|---|---|---|---|---|---|
| Epoxy resin | A-1 | 100 | | | | |
| | A-2 | | 100 | | | |
| | A-3 | | | 100 | | |
| | A-4 | | | | 100 | |
| | A-5 | | | | | 100 |
| | Property | liquid | solid | solid | solid | solid |
| | Viscosity (Pa·s) | 943 | | | | |
| | Softening point (°C) | - | 97 (meltin g point) | 115 (meltin g point) | 105 (melting point) | 91 |
| | 150°C melting viscosity (dPa·s) | 0.14 | 0.27 | 0.57 | 0.18 | 4.5 |
| Curing accelerator | 2E4MZ | 2 | 2 | 2 | 2 | |
| | 2PHZ-PW | | | | | 5 |
| Physical properties of curing product | Tg (DMA) | >350 | >350 | >350 | 193 | 326 |
| | 5% weight reduction temperature (°C) | 395 | 396 | 395 | 365 | 381 |
| | Coefficient of linear expansion (ppm) | 87 | 84 | 68 | 118 | -^{*1} |
| | Thermal conductivity (W/m·K) | 0.36 | 0.31 | 0.31 | 0.25 | 0.22 |
| Solvent solubility | | A | A | A | A | B |

| | | | | | | |
|---|---|---|---|---|---|---|
| *1 The cured product was brittle and a sample with a sufficient size to be measured could not be cut out. *2 For Comparison and/or reference only. | | | | | | |

### [Example 4 and Comparative Examples 3 to 5]

Using the epoxy resin (A-1) of the present invention obtained in Synthesis Example 1, 3,3',5,5'-tetramethyl-4,4'-biphenol type epoxy resin (A-4) as a comparative epoxy resin, a naphthalene type tetrafunctional epoxy resin HP-4700 (manufactured by DIC Corporation) (A-5), trimethylolpropane polyglycidyl ether (SR-TMPL (manufactured by Sakamoto Yakuhin kogyo Co., Ltd.) as a reactive diluent, imidazole (2P4MHZ-PW (manufactured by Shikoku Chemicals Corporation)) as a curing accelerator, and a commercially available silane coupling treated alumina (AC9500-SCX manufactured by Admatechs) as an inorganic filler, the components were blended in compositions shown in Table 2, and a resin was kneaded using a triple roll at a temperature higher than the melt temperature of the resin, followed by defoaming, whereby a resin composition was produced. Using the obtained resin composition, a resin cured product test piece (60 × 110 × 0.8 mm) was produced by a thermal press molding (temporal curing condition: 170°C × 20 minutes, main curing condition: 170°C × 2 hours). For the obtained cured product, a thermal conductivity was measured according to the method described above. Furthermore, after the obtained cured product was allowed to stand in a drying oven at 175°C for 1,000 hours, a thermal conductivity was measured, and the case where the retention rate of thermal conductivity was 90% or more was rated as "A", and the case of 90% or less was rated as "B". The results are shown in Table 2.

**[Table 2]**

| | | Example 4 | Comparative Example 3 | Comparative Example 4 | Comparative Example 5 |
|---|---|---|---|---|---|
| Epoxy resin | A-1 | 15 | | | |
| | A-4 | | 15 | | |
| | A-5 | | | 25 | 7.5 |
| Diluent | TMPL | | | | 7.5 |
| Curing accelerator | 2P4MHZ-PW | 0.3 | 0.3 | 0.3 | 0.3 |
| Filler | AC9500-SCX | 85 | 85 | 75 | 85 |
| Filler filling rate (vol%) | | 65 | 65 | 50*2 | 65 |
| Thermal conductivity (W/m·K) | | 4.2 | 3.3 | 1.3 | 2.9 |
| Thermal conductivity after heat resistance test (W/m·K) | | 4.1 | 2.8 | 1.2 | 2.2 |
| Retention rate of thermal conductivity | | A | B | A | B |

| | | | | | |
|---|---|---|---|---|---|
| *2 Filler filling limit amount | | | | | |

As can be seen from the results in Table 1 and Table 2, the polyfunctional biphenyl type epoxy resin represented by the formula (1) of the present invention that is a triglycidyloxybiphenyl or a tetraglycidyloxybiphenyl has a low melting point and low viscosity and shows good solvent solubility, and a cured product thereof shows excellent high thermal conductivity due to the biphenyl skeleton, and excellent heat resistance and excellent low thermal expansion in a high temperature region due to the polyfunctional design. In addition, since the epoxy resin of the present invention has low viscosity, there is no need to use together a diluent which has low heat resistance and low thermal conductivity, and can alone be highly filled with an inorganic filler. Accordingly, a cured product containing an inorganic filler shows an extremely excellent thermal conductivity due to high thermal conductivity of the resin itself and thermal conductivity enhancing effect by high filling with a filler. Furthermore, owing to the excellent heat resistance, the epoxy resin cured product for electronic material of the present invention can retain excellent thermal conductivity also after a heat resistance test.

### Industrial Availability

The epoxy resin composition of the present invention is useful for an electronic material, particularly for a heat dissipating material, and can be suitably used particularly for a thermal conductive adhesive, a semiconductor encapsulation material, and a material for an electronic circuit board.

## Claims

1. An epoxy resin composition for electronic material, comprising an epoxy resin, at least one of a curing agent and a curing accelerator, and a thermal conductive filler having a thermal conductivity of 10 W/m/K or higher,
wherein the epoxy resin is represented by the following formula (1): 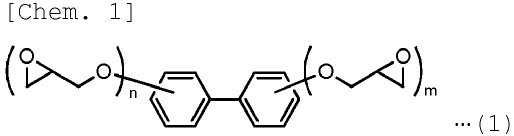 wherein n and m each represents an integer of 0 to 4, provided that the sum of n and m is 3 or 4,
wherein the thermal conductive filler has been surface modified by a silane-based coupling agent, and
wherein the thermal conductivity is measured as in the specification.

2. The epoxy resin composition for electronic material according to claim 1, further comprising a fibrous base material.

3. The epoxy resin composition for electronic material according to claim 1, which is a thermal conductive adhesive.

4. The epoxy resin composition for electronic material according to claim 1, which is for a semiconductor encapsulation material.

5. The epoxy resin composition for electronic material according to claim 1 or 2, which is for an electronic circuit board material.

6. An epoxy resin cured product for electronic material, which is obtained by subjecting the epoxy resin composition for electronic material as set forth any one of claims 1 to 5 to a curing reaction.

7. An electronic component comprising the epoxy resin cured product for electronic material as set forth in claim 6.

8. The electronic component according to claim 7, which is a thermal conductive adhesive.

9. The electronic component according to claim 7, which is a semiconductor encapsulation material.

10. The electronic component according to claim 7, which is an electronic circuit board.

## Patentansprüche

1. Epoxyharzzusammensetzung für elektronisches Material, umfassend ein Epoxyharz, mindestens eines von einem Härtungsmittel und einem Härtungsbeschleuniger und einen thermisch leitfähigen Füllstoff mit einer thermischen Leitfähigkeit von 10 W/m/K oder höher,
wobei das Epoxyharz durch die folgende Formel (1) dargestellt wird: 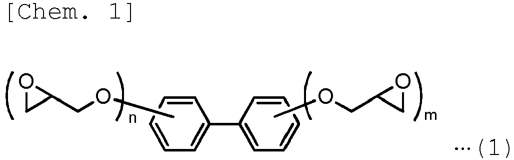 wobei gilt: n und m stehen jeweils für eine ganze Zahl von 0 bis 4, mit der Maßgabe, dass die Summe von n und m 3 oder 4 ist,
wobei der thermisch leitfähige Füllstoff oberflächenmodifiziert worden ist durch ein Kupplungsmittel auf Silanbasis und
wobei die thermische Leitfähigkeit wie in der Beschreibung angegeben gemessen wird.

2. Epoxyharzzusammensetzung für elektronisches Material nach Anspruch 1, des Weiteren umfassend ein faseriges Grundmaterial.

3. Epoxyharzzusammensetzung für elektronisches Material nach Anspruch 1, welches ein thermisch leitfähiger Klebstoff ist.

4. Epoxyharzzusammensetzung für elektronisches Material nach Anspruch 1, welches für ein Halbleiterverkapselungsmaterial ist.

5. Epoxyharzzusammensetzung für elektronisches Material nach Anspruch 1 oder 2, welches für ein elektronisches Leiterplattenmaterial ist.

6. Epoxyharz-gehärtetes Produkt, für elektronisches Material, welches erhalten wird, indem die Epoxyharzzusammensetzung für elektronisches Material nach einem der Ansprüche 1 bis 5 einer Härtungsreaktion unterworfen wird.

7. Elektronische Komponente, umfassend das Epoxyharzgehärtete Produkt für elektronisches Material nach Anspruch 6.

8. Elektronische Komponente nach Anspruch 7, welche ein thermisch leitfähiger Klebstoff ist.

9. Elektronische Komponente nach Anspruch 7, welche ein Halbleiterverkapselungsmaterial ist.

10. Elektronische Komponente nach Anspruch 7, welche eine elektronische Leiterplatte ist.

## Revendications

1. Composition de résine époxy pour matériau électronique, comprenant une résine époxy, au moins un élément parmi un agent de durcissement et un agent favorisant le durcissement, et une charge thermiquement conductrice ayant une conductivité thermique de 10 W/m/K ou plus,
dans laquelle la résine époxy est représentée par la formule (1) suivante : 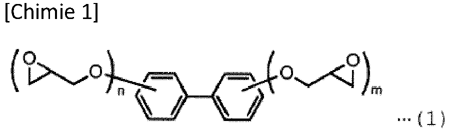 dans laquelle n et m représentent chacun un nombre entier de 0 à 4, à condition que la somme de n et m soit égale à 3 ou 4,
dans laquelle la charge thermiquement conductrice a été modifiée en surface par un agent de couplage à base de silane, et
dans laquelle la conductivité thermique est mesurée comme dans la spécification.

2. Composition de résine époxy pour matériau électronique selon la revendication 1, comprenant en outre un matériau de base fibreux.

3. Composition de résine époxy pour matériau électronique selon la revendication 1, qui est un adhésif conducteur thermique.

4. Composition de résine époxy pour matériau électronique selon la revendication 1, qui est destinée à un matériau d'encapsulation de semi-conducteur.

5. Composition de résine époxy pour matériau électronique selon la revendication 1 ou 2, qui est destinée à un matériau de carte de circuit électronique.

6. Produit durci de résine époxy pour matériau électronique, qui est obtenu en soumettant la composition de résine époxy pour matériau électronique selon l'une quelconque des revendications 1 à 5 à une réaction de durcissement.

7. Élément électronique comprenant le produit durci de résine époxy pour matériau électronique tel que défini dans la revendication 6.

8. Élément électronique selon la revendication 7, qui est un adhésif conducteur thermique.

9. Élément électronique selon la revendication 7, qui est un matériau d'encapsulation de semi-conducteur.

10. Élément électronique selon la revendication 7, qui est une carte de circuit électronique.
